# FASCICULE DE BREVET EUROPEEN

(11) **EP 1 327 156 B1**
(45) Date de publication et mention de la délivrance du brevet: **18.08.2004**
(21) Numéro de dépôt: 01949534.0
(22) Date de dépôt: 26.06.2001
(51) Int. Cl.: G01R 31/311

(54) **PROCEDE D'INDIVIDUALISATION D'UN ELEMENT DE CIRCUIT INTEGRE**
VERFAHREN ZUR INDIVIDUALISIERUNG EINES ELEMENTS EINER INTEGRIERTEN SCHALTUNG
METHOD FOR ISOLATING AN INTEGRATED CIRCUIT ELEMENT

(30) Priorité: 28.06.2000 FR 0008337
(43) Date de publication de la demande: 16.07.2003
(73) Titulaire: CENTRE NATIONAL D'ETUDES SPATIALES, 75001 Paris (FR)
(72) Inventeur: DESPLATS, Romain, F-31400 Toulouse (FR); PERDU, Philippe, F-31100 Toulouse (FR)
(74) Mandataire: Habasque, Etienne Joel Jean-François
(86) Numéro de dépôt international: PCT/FR2001/002024
(87) Numéro de publication internationale: WO 2002/001239

(56) Documents cités:
- FR-A- 2 786 011
- GB-A- 924 432
- RUSSELL J D ET AL: "E-BEAM TESTING USING MULTIPLE ADJACENT IMAGE PROCESSING FOR PROTOTYPE VALIDATION" MICROELECTRONIC ENGINEERING,NL,ELSEVIER PUBLISHERS BV., AMSTERDAM, vol. 16, no. 1 / 04, 1 mars 1992 (1992-03-01), pages 413-420, XP000245368 ISSN: 0167-9317
- NIKAWA K ET AL: "VLSI FAULT LOCALIZATION USING ELECTRON BEAM VOLTAGE CONTRAST IMAGE.Ö-NOVEL IMAGE ACQUISITION AND LOCALIZATION METHOD-" JAPANESE JOURNAL OF APPLIED PHYSICS,JP,PUBLICATION OFFICE JAPANESE JOURNAL OF APPLIED PHYSICS. TOKYO, vol. 31, no. 12B, PART 01, 1 décembre 1992 (1992-12-01), pages 4525-4530, XP000415470 ISSN: 0021-4922

## Description

La présente invention concerne un procédé d'individualisation d'un élément de circuit intégré.

Afin de procéder à l'analyse d'un circuit intégré formé sur un substrat semi-conducteur, il est nécessaire de réaliser des analyses optiques du circuit en fonctionnement, par exemple par microscopie à émission de lumière ou à l'aide d'un microscope électronique à balayage.

FR2786011 décrit un procédé graphique pour comparer le comportement de deux circuits intégré. Un opération graphique est exécuté sur les images des circuit (par exemple electron beam image), qui démontre les éléments de circuit intégré avec un comportement différent.

Toutefois, il est difficile de localiser sur le circuit réel le point exact du circuit où la mesure doit être effectuée. Cette localisation est d'autant plus difficile que dans de nombreux cas, par exemple pour les circuits programmables, la configuration exacte du circuit réel n'est pas connue. Ainsi, les coordonnées réelles des pistes du circuit ne sont pas disponibles. En outre, la taille des pistes du circuit est souvent inférieure à l'erreur du positionnement de l'outil d'observation du circuit.

En revanche, le schéma électrique du circuit est généralement disponible, même si le tracé réel du circuit sur le substrat semi-conducteur n'est pas disponible.

L'invention a pour but de proposer un procédé d'individualisation d'un élément de circuit intégré dont le tracé réel n'est pas nécessairement connu, qui permette à partir du tracé théorique du circuit, par exemple d'effectuer une mesure directement sur le circuit réel à l'endroit de l'élément du circuit ainsi individualisé.

A cet effet, l'invention a pour objet un procédé d'individualisation d'un élément de circuit intégré, caractérisé en ce qu'il comporte les étapes consistant en :
a) déterminer à partir d'un modèle du circuit, un ensemble de vecteurs correspondant chacun à un instant de fonctionnement théorique du circuit lors de l'application d'une séquence de tests prédéterminée, les coefficients de chaque vecteur étant représentatifs de l'état d'un même ensemble d'éléments du circuit parmi lesquels figurent l'élément à individualiser ;
b) définir à partir d'une comparaison des vecteurs, une composée d'opérateurs logiques appliqués sur lesdits vecteurs et permettant d'extraire le coefficient correspondant auxdits éléments à individualiser ;
c) réaliser des images du circuit en fonctionnement aux instants correspondants aux vecteurs sur lesquels est appliquée ladite composée d'opérateurs logiques ; et
d) combiner graphiquement les images réalisées suivant une composée d'opérateurs graphiques correspondant à ladite composée d'opérateurs logiques.

Selon des modes particuliers de mise en oeuvre, le procédé comporte l'une ou plusieurs des caractéristiques suivantes :
- l'étape b) de définition d'une composée d'opérateurs logiques comporte une étape récursive de comparaison d'un vecteur de la matrice et d'un vecteur résultat obtenu à partir d'une comparaison antérieure ;
- l'étape b) de définition d'une composée d'opérateurs logiques comporte l'élaboration d'un arbre dont les noeuds sont constitués des résultats des comparaisons effectuées ;
- ledit ensemble de vecteurs est un ensemble de vecteurs binaires, les coefficients étant représentatifs de l'état logique de l'élément de circuit associé ;
- ledit ensemble de vecteurs est un ensemble de vecteurs ternaires, les coefficients étant représentatifs d'un changement d'état logique de l'élément de circuit associé ; et
- il comporte, avant l'étape b) de définition d'une composée d'opérateurs logiques, une étape de classement des vecteurs afin d'augmenter leur diversité.

L'invention a en outre pour objet un dispositif d'individualisation d'un élément de circuit intégré, caractérisé en ce qu'il comporte :
- des moyens pour déterminer à partir d'un modèle du circuit, un ensemble de vecteurs correspondant chacun à un instant de fonctionnement électrique du circuit lors de l'application d'une séquence de tests prédéterminée, les coefficients de chaque vecteur étant représentatifs de l'état d'un même ensemble d'éléments du circuit parmi lesquels figurent l'élément à individualiser ;
- des moyens pour définir à partir d'une comparaison des vecteurs, une composée d'opérateurs logiques appliqués sur lesdits vecteurs et permettant d'extraire le coefficient correspondant auxdits éléments à individualiser ;
- des moyens pour réaliser des images du circuit en fonctionnement aux instants correspondants aux vecteurs sur lesquels est appliquée ladite composée d'opérateurs logiques ; et
- des moyens pour combiner graphiquement les images réalisées suivant une composée d'opérateurs graphiques correspondant à ladite composée d'opérateurs logiques.

L'invention sera mieux comprise à l'aide de la description qui va suivre, donnée uniquement à titre d'exemple et faite en se référant aux dessins sur lesquels :
- la figure 1 est un organigramme du procédé d'individualisation d'un élément de circuit intégré selon l'invention ;
- la figure 2 est une représentation d'un arbre binaire obtenu au cours de la mise en oeuvre de l'algorithme illustré sur l'organigramme de la figure 1 ;
- la figure 3 est une représentation d'un arbre binaire illustrant les combinaisons d'images à mettre en oeuvre pour individualiser les différents éléments d'un circuit intégré ;
- la figure 4 est une vue en élévation d'une partie d'un circuit intégré ;
- les figures 5 à 15 sont des vues analogues à celle de la figure 4 lors de l'application de vecteurs de test distincts aux entrées du circuit ;
- la figure 16 est un organigramme des étapes initiales de procédé d'individualisation d'un élément de circuit intégré à partir d'une matrice ternaire ;
- la figure 17 est une représentation d'un arbre obtenu par mise en oeuvre du procédé selon l'invention à partir d'une matrice ternaire ; et
- la figure 18 est un ensemble d'images traitées d'une même partie d'un circuit intégré.

Le procédé selon l'invention permet de retrouver, sur un circuit intégré existant, la position exacte d'un élément du circuit, tel qu'une piste, sans que le tracé exact du circuit intégré ne soit connu. Le tracé du circuit est généralement désigné par « layout » en anglais.

Pour la mise en oeuvre de l'algorithme, il est nécessaire de connaître le schéma électrique du circuit intégré, ou au moins l'état logique des différentes pistes du circuit en fonction d'une séquence de tests prédéterminée appliquée à l'entrée du circuit.

La localisation de l'élément défectueux s'effectue sur une image du circuit, ou d'une partie du circuit. Cette image est traitée pour laisser apparaître seulement l'élément recherché en individualisant celui-ci par rapport aux autres éléments figurant normalement sur l'image du circuit. L'élément recherché étant ainsi individualisé sur une image du circuit, il est possible à partir des coordonnées de l'élément sur l'image, de retrouver la position de cet élément sur le circuit intégré proprement dit et donc d'appliquer un appareil de mesure exactement sur l'élément ainsi identifié du circuit.

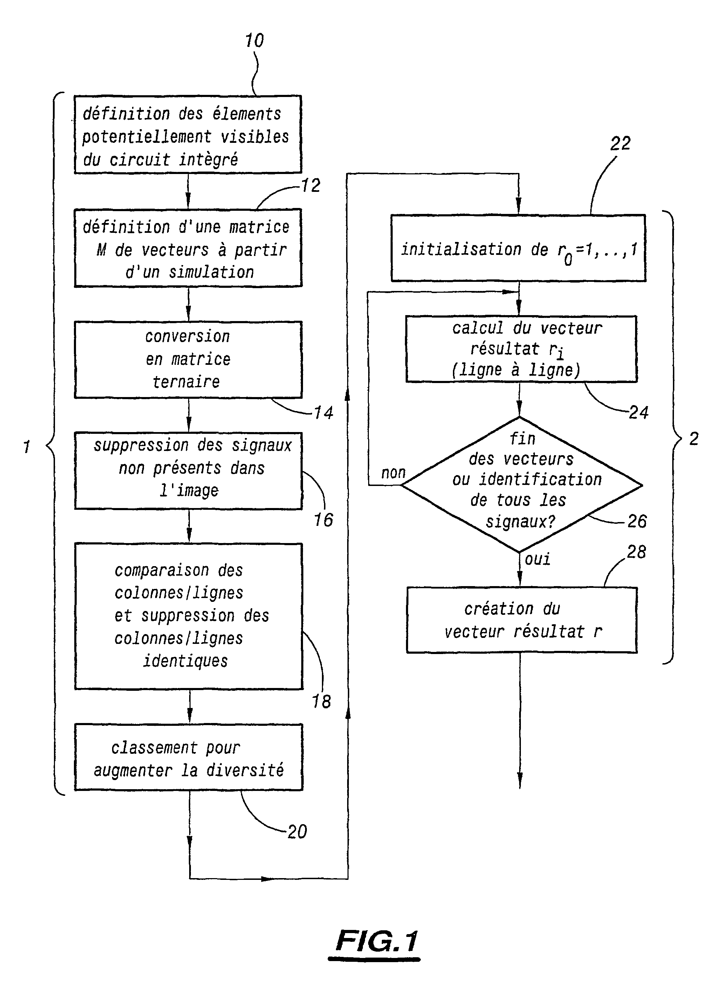

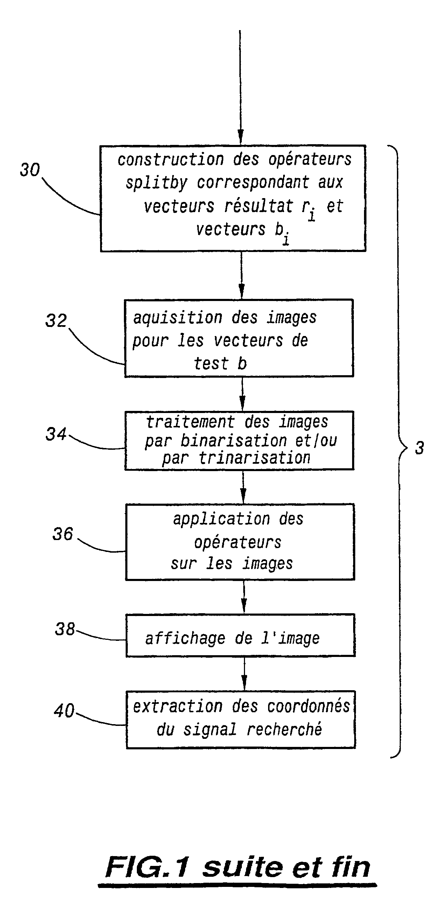

Le procédé selon l'invention, dont l'algorithme est donné sur la figure 1, comporte trois phases successives.

La première phase 1 consiste à construire, à partir du schéma théorique du circuit intégré, une structure de données représentative du fonctionnement théorique du circuit en fonction d'une séquence de tests prédéfinie. Avantageusement, cette structure de données a la forme d'une matrice M dont les coefficients sont caractéristiques de l'état logique d'un ensemble d'éléments déterminés du circuit lors de l'application de la séquence de tests prédéfinie.

Cette première phase intègre des traitements préalables effectués sur la matrice M. Ils permettent d'optimiser la mise en oeuvre des phases suivantes.

La deuxième phase 2 consiste en l'obtention d'un arbre dont la structure est représentative du traitement qui doit être effectué sur un ensemble d'images du circuit en fonctionnement afin d'obtenir une individualisation d'un élément donné du circuit sur une image traitée obtenue par combinaison de certaines images du circuit en fonctionnement.

La troisième phase 3 consiste à réaliser des images du circuit intégré en fonctionnement à certains instants identifiés de la séquence de tests donnée et à combiner ces images suivant une séquence fournie par la structure de l'arbre précédemment créé en fonction de l'élément du circuit dont l'individualisation est recherchée.

L'algorithme de la figure 1 va maintenant être décrit de manière détaillée et appliqué sur un exemple illustrant chacune des étapes.

Lors de l'étape initiale 10 de la phase 1, un ensemble d'éléments du circuit intégré potentiellement visibles sur une image du circuit en fonctionnement est défini. Dans l'exemple très simplificateur considéré ici, on suppose que ces éléments sont au nombre de dix et qu'ils sont formés par des pistes ménagées dans le matériau supraconducteur. Ces pistes sont notées a₁ à a₁₀.

Dans la pratique, la surface complète du circuit est divisée en zones voisines formées par exemple de surfaces carrées adjacentes délimitées par une grille. Les images ainsi obtenues d'une partie seulement du circuit intégré contiennent un nombre réduit d'éléments potentiellement visibles. Ce nombre est de préférence compris entre 50 et 100 éléments par image.

A partir du schéma électrique du circuit, une simulation informatique du fonctionnement de celui-ci est effectuée à l'étape 12 afin de déterminer les états logiques des éléments a₁ à a₁₀ lors de l'application d'une séquence de tests prédéterminée à l'entrée du circuit intégré.

Cette séquence de tests consiste à appliquer des valeurs d'entrée prédéterminées suivant un séquencement également prédéterminé. A chaque instant au cours du fonctionnement du circuit tel que simulé par le modèle informatique, les états logiques des éléments a₁ à a₁₀ sont mémorisés dans des vecteurs notés b₁ à b₁₀. Chaque vecteur correspond à un instant de test prédéterminé et ses coefficients sont les états logiques des éléments a₁ à a₁₀ à cet instant.

Dans l'exemple considéré, seuls dix vecteurs b₁ à b₁₀ correspondant à dix instants de test successifs sont considérés. Dans la pratique, le nombre d'instants de tests considérés est compris entre 500 et 1000.

A l'issue de la mise en oeuvre de l'étape 12, la simulation informatique du circuit permet d'obtenir une matrice binaire M telle que définie ci-dessous.

### Matrice M :

| | **a**_{**1**} | **a**_{**2**} | **a**_{**3**} | **a**_{**4**} | **a**_{**5**} | **a**_{**6**} | **a**_{**7**} | **a**_{**8**} | **a**_{**9**} | **a**_{**10**} |
|---|---|---|---|---|---|---|---|---|---|---|
| **b**_{**1**} = | 0 | 1 | 0 | 0 | 1 | 0 | 1 | 0 | 0 | 1 |
| **b**_{**2**} = | 0 | 1 | 0 | 1 | 0 | 1 | 0 | 1 | 0 | 1 |
| **b**_{**3**} = | 1 | 0 | 0 | 1 | 0 | 1 | 1 | 1 | 1 | 0 |
| **b**_{**4**} = | 1 | 0 | 1 | 0 | 1 | 0 | 0 | 0 | 1 | 1 |
| **b**_{**5**} = | 1 | 0 | 1 | 1 | 0 | 1 | 1 | 1 | 1 | 1 |
| **b**_{**6**} = | 0 | 0 | 0 | 0 | 0 | 0 | 0 | 0 | 0 | 0 |
| **b**_{**7**} = | 1 | 1 | 1 | 1 | 0 | 1 | 1 | 1 | 1 | 1 |
| **b**_{**8**} = | 0 | 1 | 0 | 0 | 0 | 0 | 0 | 0 | 0 | 1 |
| **b**_{**9**} = | 1 | 0 | 0 | 0 | 1 | 0 | 1 | 0 | 0 | 1 |
| **b**_{**10**} = | 1 | 0 | 0 | 1 | 1 | 1 | 1 | 1 | 0 | 1 |

Dans cette matrice, les vecteurs b₁ à b₁₀ figurent en ligne. Ils comportent chacun comme coefficients, des coefficients représentatifs de l'état logique des éléments a₁ à a₁₀.

Après la définition de cette matrice M, une étape facultative 14 de conversion de la matrice binaire en matrice ternaire est mise en oeuvre en fonction du type d'appareil d'analyse devant être utilisé pour l'observation du circuit intégré en fonctionnement.

Lorsque l'équipement d'analyse est constitué d'un microscope à émission de lumière, la matrice binaire initialement formée est laissée en l'état, de sorte que l'étape 14 est omise. Au contraire, si l'équipement d'analyse est constitué d'un microscope électronique à balayage, une matrice ternaire est formée à partir de la matrice binaire initialement créée.

Pour la suite de la description de l'algorithme, on considèrera qu'un microscope à émission de lumière est mis en oeuvre, de sorte que la matrice binaire n'a pas à être convertie en une matrice ternaire. La mise en oeuvre de l'étape 14 sera décrite séparément à l'issue de la description complète de l'algorithme.

Aux étapes suivantes 16 à 20 achevant la phase 1, des traitements préalables sont effectués sur la matrice M afin d'augmenter la vitesse de mise en oeuvre de l'algorithme.

En particulier, à l'étape 16, les éléments non présents dans une image de la région considérée du circuit sont supprimés. A cet effet, les colonnes correspondant à des éléments potentiellement non visibles sur l'image considérée sont supprimées. Par exemple, lors de l'analyse avec un microscope électronique à balayage, on ne considérera que les éléments non visibles correspondant à des pistes métalliques enterrées. Pour déterminer si un élément est visible, on utilise la correspondance entre les noms des éléments du schéma électrique et les numéros des polygones correspondants dans le "layout" sous réserve que celui-ci soit disponible.

Si pour un élément recherché, il n'existe aucun polygone en métal supérieur avec le numéro de "layout" correspondant, on exclut alors la colonne A l'étape 18, les lignes et les colonnes de la matrice sont comparées entre elles. Les lignes ou les colonnes identiques sont supprimées afin d'éviter des traitements ultérieurs inutiles.

A l'étape 20 suivante, les vecteurs correspondants aux différents instants de test sont classés de manière à augmenter leur diversité. Ce classement visant à augmenter la diversité consiste en des permutations entre les différentes lignes de la matrice. Cette diversité est obtenue en classant les vecteurs par ordre du poids le plus fort au poids le plus faible puis en réorganisant les vecteurs en alternant les vecteurs de poids les plus forts et les vecteurs de poids les plus faibles.

Dans l'exemple considéré pour illustrer la mise en oeuvre de l'algorithme, on suppose que tous les éléments considérés sont potentiellement présents dans l'image de sorte que la mise en oeuvre de l'étape 16 est sans incidence.

Les étapes 16 à 20 sont facultatives, Ici, les étapes 18 et 20 ont été omises.

A l'issue de la phase 1 de définition de la matrice M, la phase 2 de création de l'arbre binaire est mise en oeuvre.

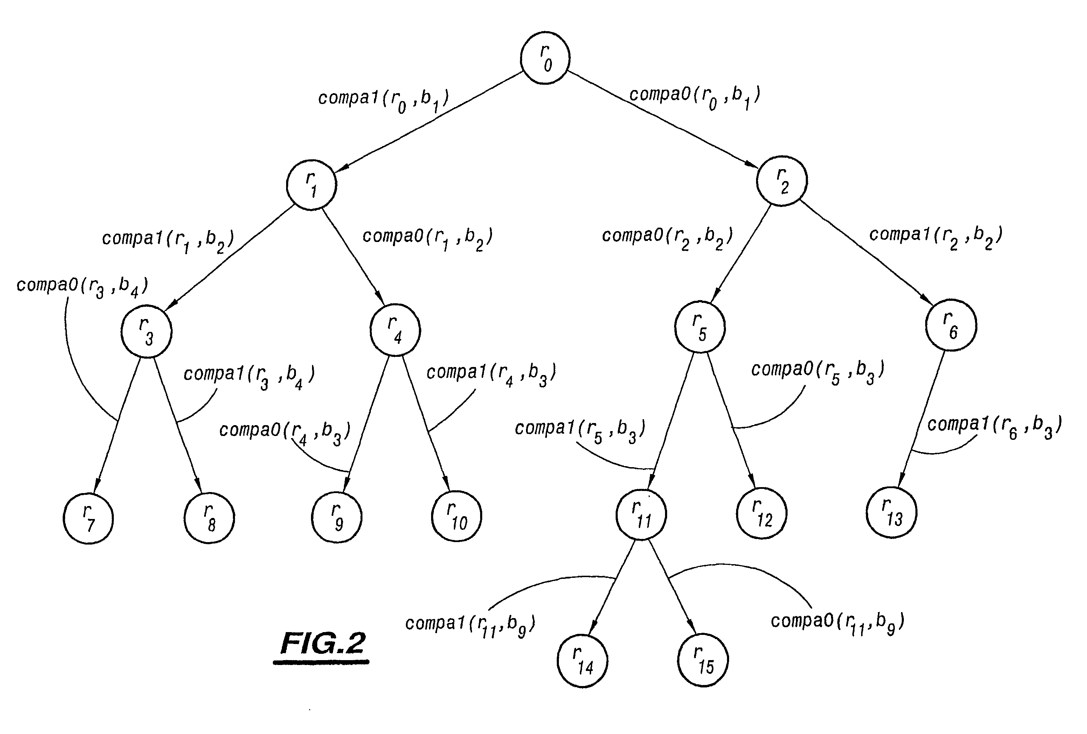

Lors de cette phase, un ensemble de vecteurs résultat notés rᵢ est constitué. Ces vecteurs forment les noeuds d'un arbre binaire illustré sur la figure 2. Ils sont constitués chacun du résultat de la comparaison effectuée entre un vecteur bᵢ de la matrice M et un autre vecteur résultat rⱼ déjà obtenu. La comparaison des vecteurs est effectuée coefficient à coefficient par mise en oeuvre de deux opérateurs logiques, notés compa0 et compa1. Les tables de vérité des deux opérateurs compa0 et compa1 sont données ci-dessous.

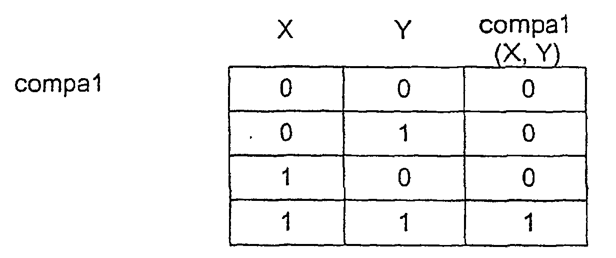

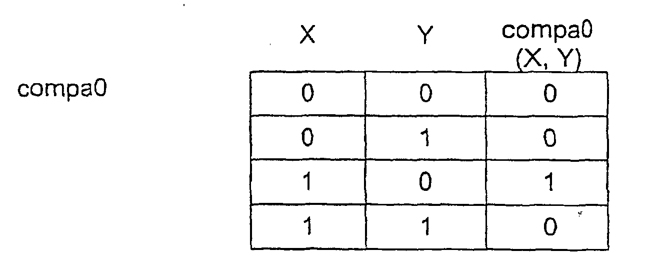

Pour chacune des tables de vérité, les valeurs possibles pour une première opérande X sont indiquées dans la première colonne, les valeurs possibles pour une seconde opérande Y sont données dans la deuxième colonne, alors que le résultat de l'opérateur logique appliqué sur les deux opérandes considérées est donné dans la dernière colonne.

Les vecteurs résultat créés lors de la mise en oeuvre de l'algorithme sont obtenus par application de ('un ou l'autre des opérateurs logiques compa0 et compa1 sur l'un des vecteurs résultat antérieurs rᵢ et sur l'un des vecteurs bᵢ de la matrice M précédemment constituée. Ainsi, les vecteurs résultat rᵢ ont le même nombre de coefficients que les vecteurs b₁ à b₁₀ de la matrice.

Chaque vecteur résultat rᵢ correspond à une image traitée de la région considérée du circuit. Cette image traitée est obtenue par une combinaison d'images réelles prises de la région considérée du circuit, à des instants de fonctionnement distincts lors de l'application de la séquence de test. Ces images sont combinées conformément à une séquence correspondant à la séquence d'obtention du vecteur résultat associé, et dont la description est donnée par la structure de l'arbre.

Les vecteurs résultat sont créés par mise en oeuvre d'un algorithme récursif au cours duquel chaque vecteur résultat est comparé à un vecteur de la matrice par mise en oeuvre de l'un et l'autre des opérateurs logiques compa0 et compa1 et ce, tant que le résultat ainsi obtenu est différent du vecteur résultat antérieur auquel est appliqué l'opérateur logique et qu'il reste des vecteurs non considérés dans la matrice M.

Au fur et à mesure de leur création, les vecteurs résultat rᵢ sont disposés dans l'arbre binaire dans lequel chaque nouveau vecteur résultat calculé a pour ancêtre le vecteur ayant servi d'opérande pour son calcul.

L'arbre construit à partir de la matrice M considérée à titre d'exemple est donné sur la figure 2. Pour la création de cet arbre, la procédure récursive est initiée à l'étape 22 (figure 1) où un premier vecteur résultat noté r₀ est pris avec tous ses coefficients égaux à 1.

Le calcul des autres vecteurs résultat s'effectue de manière récursive à l'étape 24 et ce, jusqu'à ce que l'ensemble des vecteurs de la matrice M soit considéré, ou que chacun des vecteurs résultat obtenus ne puisse plus être comparé à l'un des vecteurs de la matrice avec un résultat différent du vecteur résultat considéré dans la comparaison. Un test de fin pour le calcul des vecteurs résultat est ainsi effectué à l'étape 26.

Avec la matrice M considérée à titre d'exemple, l'algorithme s'applique de la manière suivante.

Le vecteur résultat r₀ est d'abord comparé au vecteur b₁ par l'application des deux opérateurs logiques compa1 et compa0 afin d'obtenir respectivement les vecteurs résultat r₁ et r₂.

Les valeurs de r₁ et r₂ sont données dans le tableau 1 qui suit.

Pour des raisons de clarté, dans toute la suite de la description, les coefficients non nuls de chaque vecteur résultat rᵢ sont fixés arbitrairement à l'entier i utilisé comme indice du vecteur résultat. Dans les tableaux, l'opérateur logique appliqué est rappelé dans la dernière colonne.

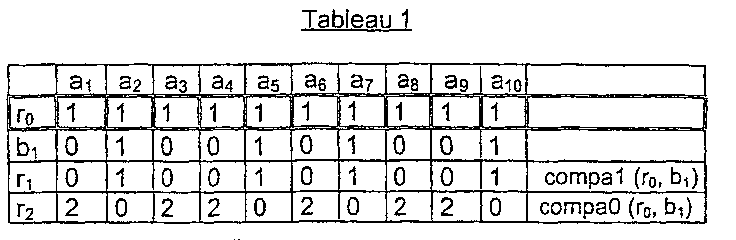

L'application des opérateurs logiques compa0 et compa1 aux vecteurs r₀ et b₁ permet d'obtenir les deux noeuds de l'arbre dépendants de la racine r₀. Chaque branche de l'arbre est associée à l'un des opérateurs logiques compa0 et compa1 comme représenté sur la figure 2.

Pour la création du deuxième niveau de l'arbre, les vecteurs résultat r₁ et r₂ sont comparés au vecteur suivant de la matrice M, c'est-à-dire au vecteur b₂ par application des deux opérateurs logiques compa0 et campa1. Ainsi, sont créés les noeuds de l'arbre correspondants aux vecteurs résultat r₃ et r₄ et qui sont rattachés au noeud correspondant au vecteur résultat r₁ ainsi que les noeuds correspondants aux vecteurs résultat r₅ et r₆ et qui sont rattachés au noeud correspondant au vecteur résultat r₂.

Les valeurs des vecteurs résultat r₃ à r₆, sont donnés dans les deux tableaux 2.1 et 2.2 qui suivent. Dans ces tableaux, les coefficients nuls des vecteurs r₁ et r₂ ont été omis pour des raisons de clarté puisque quelle que soit la valeur des coefficients du vecteur auquel ils sont comparés, le résultat de l'opérateur logique est 0 d'après la définition des opérateurs compa0 et campa1.

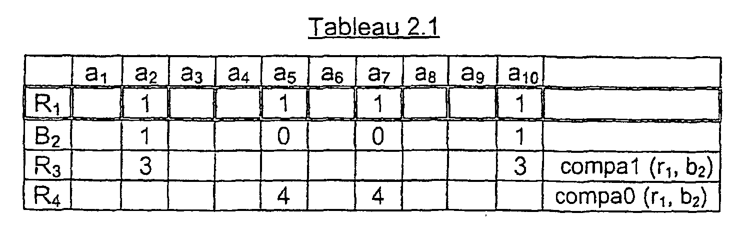

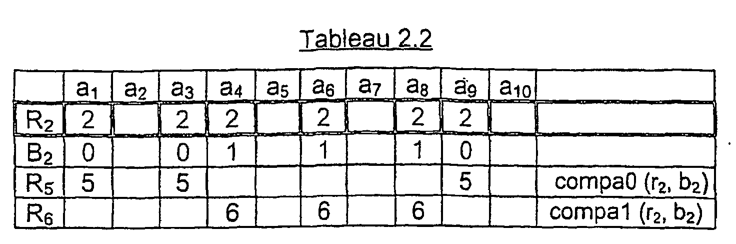

Pour la création du troisième niveau de l'arbre, l'algorithme se poursuit par la comparaison du vecteur résultat r₃ et du vecteur b₃ de la matrice. Toutefois, et comme cela apparaît dans le tableau 3.1 figurant ci-dessous, les coefficients des vecteurs r₃ et b₃ sont analogues, de sorte que le résultat de leur comparaison ne conduit pas à la définition d'un vecteur résultat non colinéaire à un vecteur résultat déjà présent dans l'arbre en cours de création.

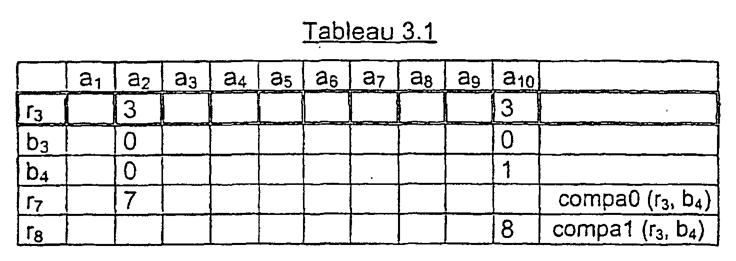

Ainsi, la comparaison entre les vecteurs r₃ et b₃ est omise. La comparaison entre le vecteur résultat r₃ et le vecteur suivant b₄ de la matrice est alors mise en oeuvre pour créer les vecteurs résultat r₇ et r₈ obtenus respectivement par l'application des opérateurs logiques compa0 et compa1.

Comme illustré sur la figure 2, les noeuds correspondant aux vecteurs résultat r₇ et r₈ sont reliés au noeud correspondant au vecteur résultat r₃ par deux branches associées respectivement aux opérateurs logiques compa0 et compa1.

Dans la mesure où les vecteurs résultat r₇ et r₈ comportent seulement un coefficient non nul, ces vecteurs n'ont plus à faire l'objet d'une comparaison ultérieure, puisque le résultat de la comparaison de ces vecteurs avec l'un quelconque des vecteurs de la matrice par application de l'opérateur logique compa0 ou compa1 conduirait soit à un vecteur nul, soit à un vecteur identique. Ces vecteurs correspondent à des feuilles de l'arbre qu'il n'est plus nécessaire de comparer à l'un quelconque des vecteurs de la matrice M.

A partir des vecteurs résultat r₄ et r₅, et par comparaison de ces deux vecteurs résultat au vecteur b₃, par application des opérateurs logiques compa0 et compa1, les vecteurs résultat r₉, r₁₀ d'une part, et r₁₁, r₁₂ d'autre part, sont obtenus. Le détail de leur calcul est donné dans les tableaux 3.2 et 3.3 ci-dessous.

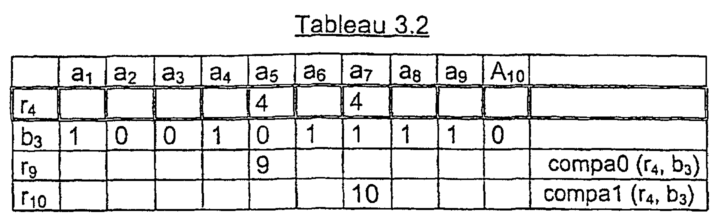

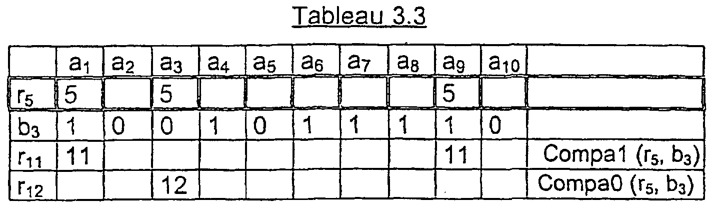

On constate sur ces tableaux 3.2 et 3.3 que les vecteurs résultat r₉, r₁₀ et r₁₂ constituent des feuilles de l'arbre alors que le vecteur résultat r₁₁ peut encore être comparé de manière pertinente à l'un des vecteurs de la matrice M, le vecteur résultat r₁₁ ayant encore deux coefficients non nuls.

Enfin, pour achever le troisième niveau de l'arbre, le vecteur résultat r₆ est comparé à un vecteur restant de la matrice M. Toutefois, comme il apparaît clairement dans le tableau 3.4 ci-dessous, quel que soit le vecteur restant de la matrice M auquel le vecteur résultat r₆ est comparé, le résultat de la comparaison par l'opérateur logique compa1 est identique au vecteur résultat r₆. Ainsi, le vecteur résultat obtenu, noté r₁₃, constitue une feuille de l'arbre reliée au noeud correspondant au vecteur résultat r₆.

Cette situation aurait pu être évitée par la mise en oeuvre de l'étape 18 qui, dans l'exemple considéré, a été omise.

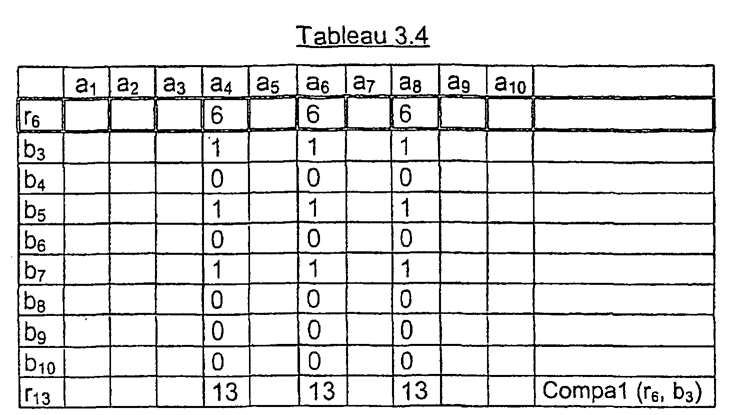

Les vecteurs résultat r₇, r₈, r₉, r₁₀, r₁₂ et r₁₃ constituant des feuilles de l'arbre, seul le vecteur résultat r₁₁ est comparé à un vecteur restant de l'arbre afin de créer les vecteurs r₁₄ et r₁₅ correspondant respectivement à l'application des opérateurs logiques compa1 et compa0.

Les valeurs des vecteurs r₁₄ et r₁₅ sont données dans le tableau 4.1 ci-dessous.

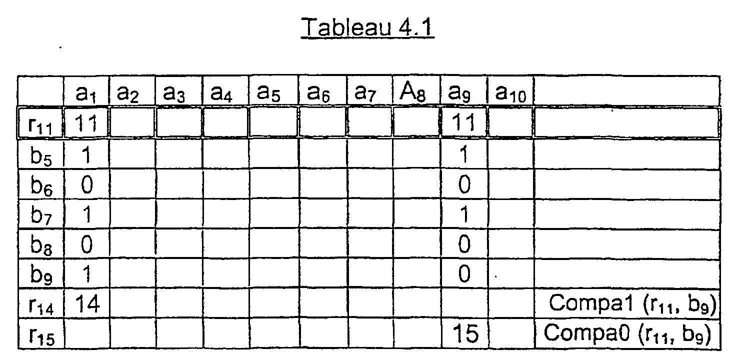

Il apparaît que la comparaison du vecteur résultat r₁₁ aux vecteurs b₅ à b₈ de la matrice est inopérante, ces vecteurs étant colinéaires. Seule la comparaison du vecteur r₁₁ avec le vecteur b₉ permet d'obtenir des vecteurs r₁₄ et r₁₅ dont les coefficients sont distincts des coefficients du vecteur r₁₁.

Les vecteurs r₁₄ et r₁₅ n'ayant qu'un seul coefficient non nul, ils constituent des feuilles de l'arbre, de sorte qu'il est mis un terme aux comparaisons entre les vecteurs de la matrice M et les vecteurs résultat rᵢ créés.

A l'issue du calcul des vecteurs r₁ à r₁₃, un vecteur résultat r est créé à l'étape 28. Ce vecteur a pour coefficients les coefficients non nuls de l'ensemble des vecteurs résultat constituant des feuilles de l'arbre. De part leur construction, les vecteurs résultat rᵢ ont en effet tous des coefficients non nuls à des positions distinctes.

Le vecteur résultat r apparaît en dernière ligne du tableau 5 ci-dessous, dans lequel les vecteurs résultat r₇, r₈, r₉, r₁₀, r₁₂, r₁₃, r₁₄ et r₁₅ constituant des feuilles de l'arbre sont repris.

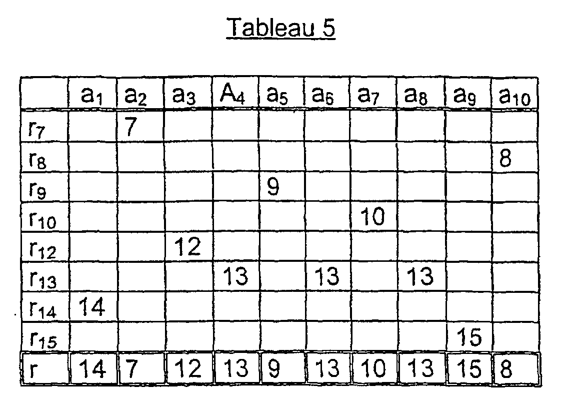

A partir du vecteur résultat r ainsi que de l'arbre représenté sur la figure 2, une combinaison d'images est déduite pour chaque élément du circuit intégré, afin d'assurer son individualisation sur une image traitée. Ces étapes font l'objet de la phase 3 de l'algorithme.

La combinaison d'images est effectuée sur des images du circuit intégré prises à des instants définis de la séquence de test appliquée au circuit.

Plus précisément, les combinaisons d'images sont réalisées par application de deux opérateurs graphiques splitby1 et splitby0 agissant sur des images pour assurer leur comparaison pixel à pixel.

L'opérateur splitby1 appliqué sur deux images du circuit conduit à créer une image résultat formée par l'application de la fonction ET sur les pixels correspondant des deux images. Cet opérateur consiste physiquement à recouvrir les zones noires d'une image par les zones blanches correspondantes de l'autre image.

L'opérateur splitby0 appliqué sur deux images du circuit conduit à créer une image résultat formée par l'application de la fonction OU sur les pixels correspondant des deux images. Cet opérateur consiste physiquement à recouvrir les zones blanches d'une image par les zones noires correspondantes de l'autre image.

Pour déterminer les comparaisons d'images devant être effectuées afin d'individualiser un élément aᵢ donné, on détermine la valeur du coefficient i du vecteur r et on considère à partir de l'arbre illustré sur la figure 2 la combinaison d'opérateurs logiques ayant permis d'obtenir le vecteur résultat rᵢ.

Pour chacune des opérations logiques effectuées depuis la racine de l'arbre jusqu'à la feuille correspondant au vecteur résultat rᵢ, on définit un opérateur graphique splitby0 ou splitby1 correspondant. Ainsi est obtenue une composée d'opérateurs graphiques, appliqués suivant une séquence inverse à la séquence d'application des opérateurs logiques compa0 et compa1 de la racine de l'arbre jusqu'à la feuille considérée.

L'opérateur graphique splitby1 est utilisé sur les images en remplacement de l'opérateur logique compa1 appliqué sur les vecteurs et l'opérateur graphique splitby0 est utilisé sur les images en remplacement de l'opérateur logique compa0 appliqué sur les vecteurs.

Alors que les opérateurs logiques compa0 et compa 1 sont appliqués sur les vecteurs bᵢ de la matrice M et sur les vecteurs résultats rᵢ, les opérateurs graphiques splitby0 et splitby1 sont appliqués sur des images du circuit en fonctionnement pris à des instants identifiés de la séquence de test et sur des images déjà traitées par application de ces opérateurs graphiques.

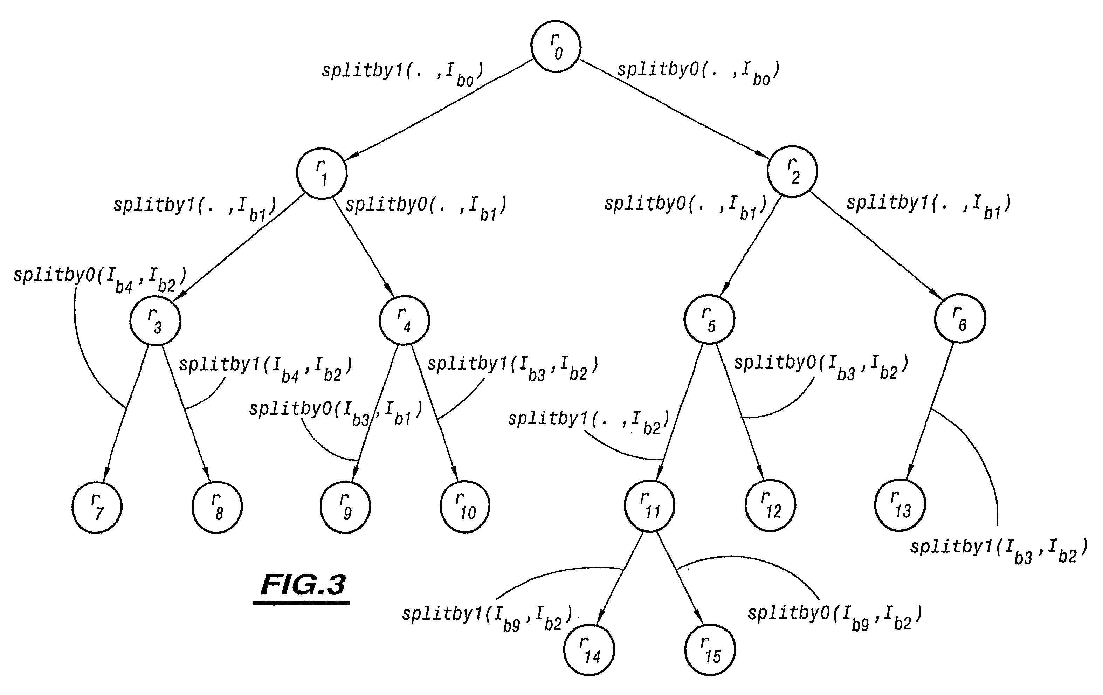

Afin d'illustrer cette transposition des opérateurs appliqués sur les vecteurs aux opérateurs appliqués sur les images, il est représenté sur la figure 3 un arbre binaire correspondant à l'arbre de la figure 2, où les opérateurs logiques compa0 et compa1 sont remplacés par les opérateurs graphiques splitby0 et splitby1. Les opérateurs graphiques sont appliqués sur les images du circuit prises aux instants correspondants aux vecteurs bᵢ de la matrice M. Ainsi sur la figure 3, l'image prise à l'instant correspondant au vecteur bᵢ est notée I_{bi}.

Sur cette figure, l'opérande marquée par un point correspond à l'image traitée obtenue par application de l'un ou l'autre des opérateurs, considérés au niveau inférieur de l'arbre.

Les opérateurs splitby1 et splitby0 sont combinés suivant l'ordre de parcours défini par l'arbre allant de la feuille rᵢ considérée à la racine r₀.

Ainsi, par exemple, pour isoler l'élément a₂, la séquence inverse à celle ayant permis d'obtenir le vecteur résultat r₇ est appliquée sur les images. En effet, le second coefficient du vecteur r correspondant à l'élément a₂ est égal à 7.

Plus précisément, et comme il apparaît sur la figure 3, pour l'individualisation de l'élément a₂ , la séquence logique suivante est définie :
- l'application de l'opérateur graphique splitby0 aux images I_{b4} et I_{b2} ;
- l'application de l'opérateur graphique splitby1 à l'image précédemment obtenue et à l'image I_{b1} ; puis
- l'application de l'opérateur graphique splitby1 à l'image précédemment obtenue et à l'image I_{b0}.

L'image I_{b0} est une image entièrement noire correspondant à un état logique égal à 1 pour tous les noeuds du circuit.

A l'issue de l'étape 30 de construction de la séquence d'opérateurs graphiques, les images nécessaires à l'application des opérateurs précédemment définis pour individualiser sur une image un élément prédéfini sont acquises à l'étape 32. Lors de cette étape, les images de la partie concernée du circuit sont mémorisées pendant l'application de la séquence de tests prédéfinie et ce, aux instants correspondants aux vecteurs bᵢ utilisés pour le calcul du vecteur résultat correspondant à l'élément du circuit à individualiser.

Lors de l'étape 34, les images sont traitées par numérisation afin de réduire leur niveau de couleurs à deux couleurs, à savoir le noir et le blanc.

A l'étape 36 ultérieure, la composée d'opérateurs splitby1 et splitby0 est appliquée sur les images acquises à l'étape 32 et traitée à l'étape 34.

A l'étape 38, l'image obtenue par application des opérateurs est affichée. L'élément à individualiser apparaît seul sur cette image. Les coordonnées de l'élément ainsi individualisé sont extraites à l'étape 40.

On conçoit que les combinaisons des images telles qu'effectuées consistant à masquer certaines parties d'une image par une partie correspondante d'une autre image de couleur différente, permet d'extraire de l'image traitée finale les éléments du circuit non désirés et de ne maintenir sur l'image traitée que l'élément dont l'individualisation est recherchée.

L'équipement d'observation du fonctionnement du circuit, à savoir dans le cas considéré un microscope à émission de lumière peut alors être déplacé jusqu'aux coordonnées relevées sur l'image afin d'étudier avec précision le fonctionnement du circuit dans la région de cet élément.

En variante, et notamment lors de l'utilisation d'un microscope électronique à balayage pour l'observation du circuit intégré en fonctionnement, l'étape facultative 14 de conversion de la matrice binaire des états logiques du circuit en une matrice ternaire est mise en oeuvre. Les coefficients de cette matrice ternaire peuvent prendre trois valeurs distinctes correspondant à trois états du circuit tels qu'ils ont été observés par le microscope électronique à balayage.

A cet effet, le passage de la matrice binaire à la matrice ternaire, les coefficients de la matrice ternaire sont fixés de la manière suivante :
N (noir) lorsque l'état logique de l'élément considéré passe de 0 à 1 ;
B (blanc) lorsque l'état logique de l'élément considéré passe de 1 à 0 ; et
G (gris) lorsque l'état de l'élément considéré reste invariant entre deux instants successifs.

Le tableau ci-dessous donne un exemple d'une matrice d'états binaires obtenue pour une séquence de test de 24 vecteurs. Les 22 éléments du circuit sont désignés par les lettres A à W.

| | élément | A | B | C | D | E | F | G | H | I | J | L | M | N | O | P | Q | R | S | T | U | V | W |
|---|---|---|---|---|---|---|---|---|---|---|---|---|---|---|---|---|---|---|---|---|---|---|---|
| vecteur | 0 | 0 | 1 | 0 | 1 | 0 | 0 | 0 | 1 | 1 | 1 | 1 | 0 | 1 | 0 | 0 | 0 | 0 | 1 | 0 | 0 | 0 | 0 |
| vecteur | 1 | 1 | 0 | 0 | 0 | 0 | 0 | 1 | 0 | 0 | 1 | 1 | 0 | 1 | 1 | 0 | 0 | 0 | 0 | 1 | 0 | 1 | 1 |
| vecteur | 2 | 0 | 1 | 1 | 0 | 0 | 1 | 0 | 0 | 0 | 0 | 1 | 1 | 0 | 1 | 1 | 0 | 0 | 0 | 0 | 0 | 0 | 1 |
| vecteur | 3 | 0 | 0 | 1 | 0 | 1 | 0 | 1 | 0 | 1 | 1 | 1 | 1 | 1 | 1 | 1 | 1 | 1 | 0 | 1 | 0 | 1 | 1 |
| vecteur | 4 | 0 | 1 | 1 | 1 | 0 | 0 | 1 | 1 | 0 | 0 | 1 | 1 | 1 | 1 | 1 | 1 | 0 | 1 | 0 | 0 | 1 | 1 |
| vecteur | 5 | 1 | 1 | 1 | 0 | 0 | 1 | 1 | 0 | 1 | 0 | 1 | 0 | 0 | 1 | 1 | 1 | 0 | 1 | 0 | 0 | 1 | 1 |
| vecteur | 6 | 1 | 0 | 0 | 1 | 1 | 1 | 0 | 1 | 0 | 0 | 1 | 0 | 0 | 0 | 0 | 1 | 0 | 0 | 1 | 1 | 1 | 0 |
| vecteur | 7 | 0 | 0 | 0 | 0 | 0 | 1 | 0 | 1 | 0 | 0 | 0 | 1 | 0 | 0 | 0 | 1 | 0 | 1 | 0 | 0 | 0 | 1 |
| vecteur | 8 | 0 | 0 | 1 | 0 | 0 | 0 | 1 | 1 | 0 | 1 | 1 | 0 | 1 | 0 | 1 | 0 | 1 | 1 | 0 | 1 | 0 | 1 |
| vecteur | 9 | 0 | 1 | 1 | 0 | 0 | 1 | 1 | 0 | 0 | 0 | 0 | 0 | 0 | 1 | 1 | 1 | 1 | 0 | 0 | 0 | 0 | 1 |
| vecteur | 10 | 1 | 0 | 0 | 0 | 1 | 0 | 0 | 0 | 0 | 1 | 0 | 1 | 0 | 1 | 0 | 1 | 1 | 0 | 0 | 1 | 1 | 0 |
| vecteur | 11 | 1 | 0 | 1 | 1 | 0 | 0 | 0 | 1 | 0 | 0 | 1 | 1 | 0 | 0 | 1 | 1 | 1 | 0 | 1 | 0 | 0 | 1 |
| vecteur | 12 | 0 | 0 | 1 | 1 | 1 | 1 | 1 | 1 | 1 | 1 | 1 | 1 | 0 | 1 | 0 | 0 | 1 | 1 | 0 | 1 | 1 | 0 |
| vecteur | 13 | 1 | 1 | 0 | 0 | 1 | 0 | 0 | 1 | 0 | 0 | 0 | 1 | 1 | 1 | 1 | 1 | 1 | 0 | 1 | 1 | 0 | 1 |
| vecteur | 14 | 0 | 0 | 1 | 0 | 0 | 0 | 1 | 1 | 0 | 0 | 1 | 0 | 1 | 1 | 0 | 0 | 1 | 1 | 0 | 1 | 1 | 0 |
| vecteur | 15 | 0 | 0 | 1 | 1 | 0 | 1 | 0 | 1 | 1 | 0 | 0 | 1 | 0 | 0 | 0 | 0 | 1 | 0 | 0 | 1 | 0 | 1 |
| vecteur | 16 | 1 | 1 | 0 | 0 | 1 | 1 | 1 | 1 | 1 | 0 | 1 | 1 | 0 | 0 | 0 | 1 | 0 | 0 | 0 | 1 | 1 | 0 |
| vecteur | 17 | 0 | 1 | 1 | 0 | 0 | 0 | 0 | 1 | 1 | 0 | 1 | 1 | 1 | 0 | 0 | 1 | 0 | 0 | 0 | 0 | 0 | 0 |
| vecteur | 18 | 1 | 0 | 0 | 1 | 1 | 0 | 0 | 0 | 0 | 0 | 1 | 0 | 1 | 0 | 0 | 1 | 0 | 1 | 0 | 1 | 0 | 0 |
| vecteur | 19 | 1 | 0 | 0 | 1 | 0 | 0 | 0 | 0 | 0 | 0 | 1 | 1 | 0 | 1 | 0 | 0 | 0 | 0 | 1 | 0 | 1 | 1 |
| vecteur | 20 | 1 | 0 | 1 | 0 | 1 | 0 | 1 | 1 | 0 | 1 | 0 | 1 | 1 | 1 | 1 | 0 | 0 | 1 | 1 | 1 | 0 | 1 |
| vecteur | 21 | 1 | 1 | 1 | 1 | 1 | 0 | 1 | 0 | 0 | 0 | 1 | 0 | 1 | 0 | 0 | 1 | 1 | 0 | 0 | 1 | 1 | 0 |
| vecteur | 22 | 0 | 1 | 1 | 0 | 0 | 0 | 0 | 1 | 1 | 1 | 1 | 1 | 1 | 1 | 0 | 1 | 1 | 1 | 1 | 0 | 0 | 0 |
| vecteur | 23 | 1 | 1 | 1 | 1 | 1 | 0 | 1 | 1 | 1 | 1 | 0 | 1 | 1 | 1 | 0 | 1 | 1 | 1 | 0 | 0 | 0 | 0 |

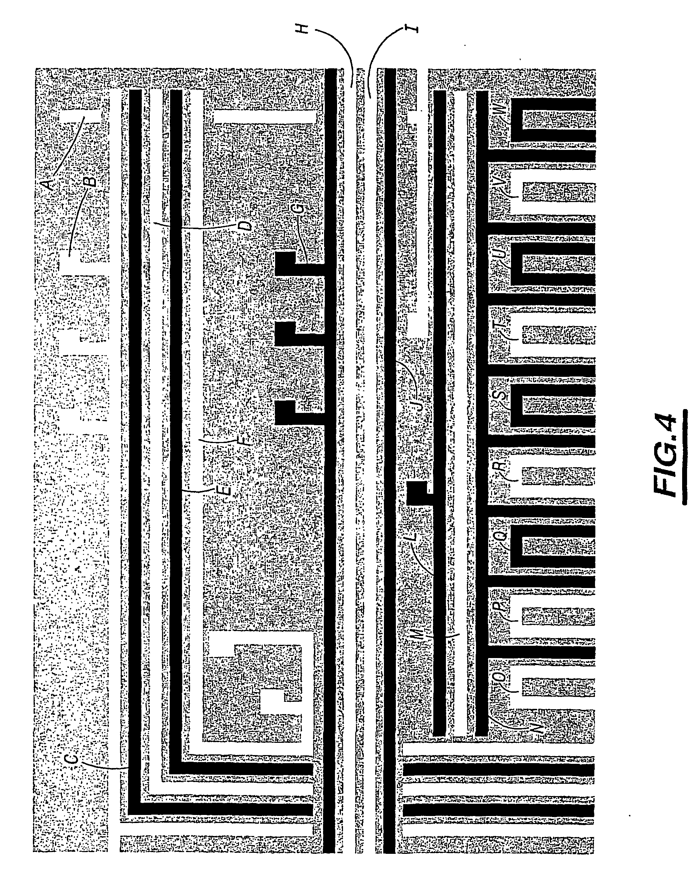

Sur la figure 4 est donnée une image du circuit sur laquelle apparaissent les 22 pistes, soit en couleur blanche, soit en couleur noire. Les pistes sont repérées par les lettres A à W.

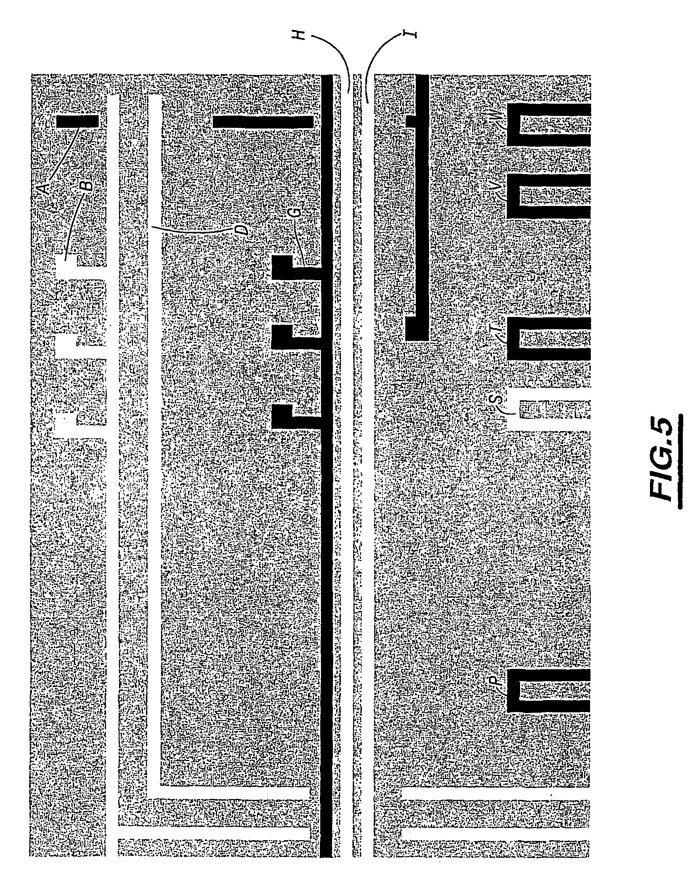

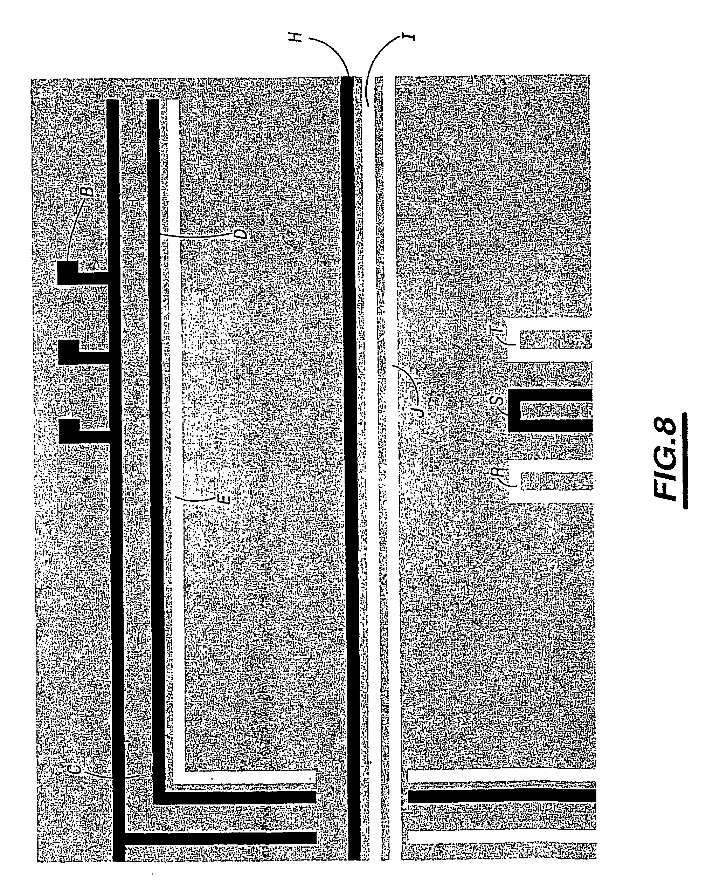

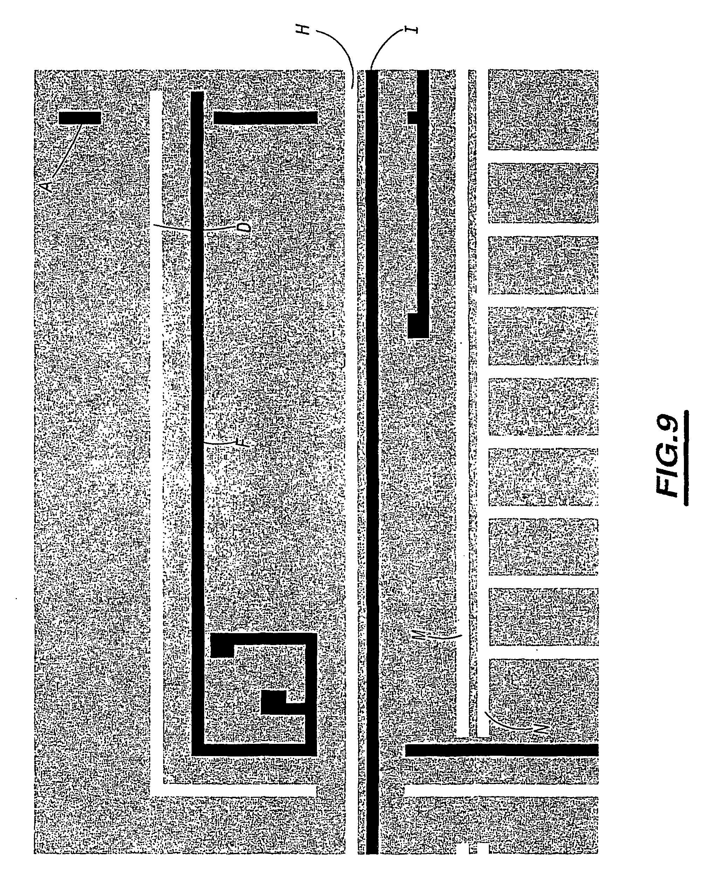

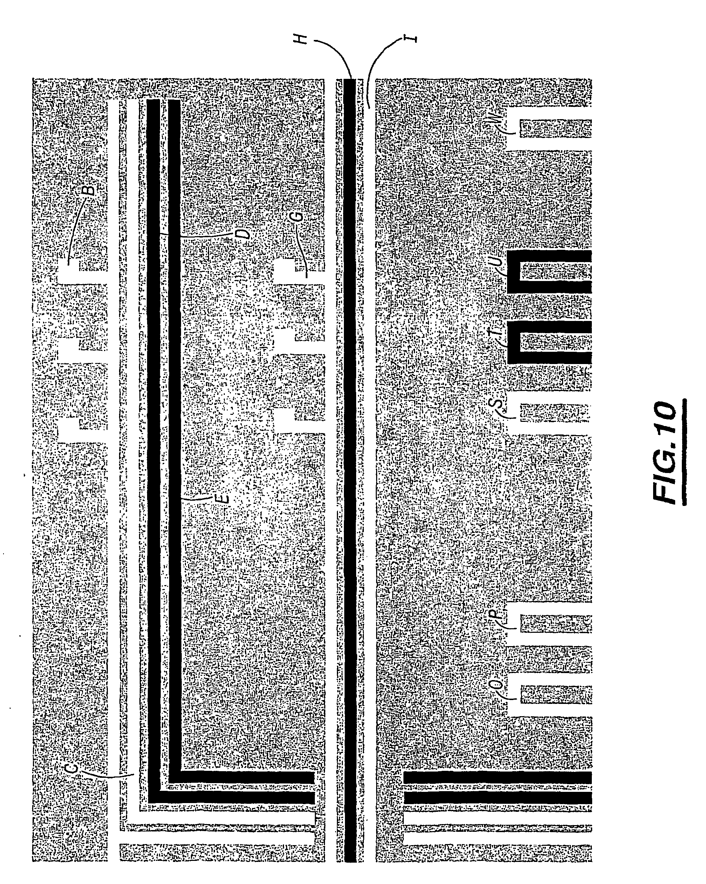

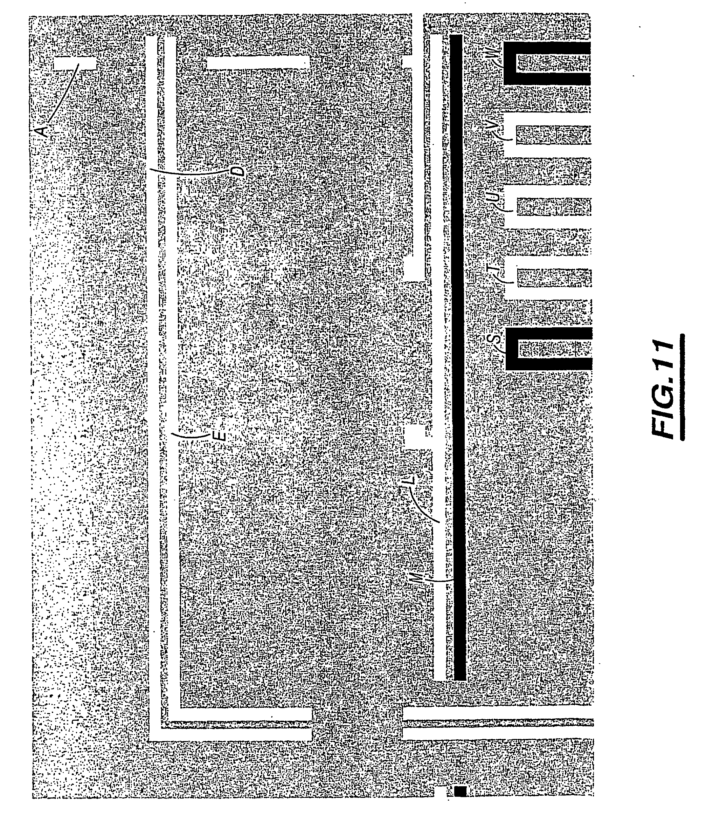

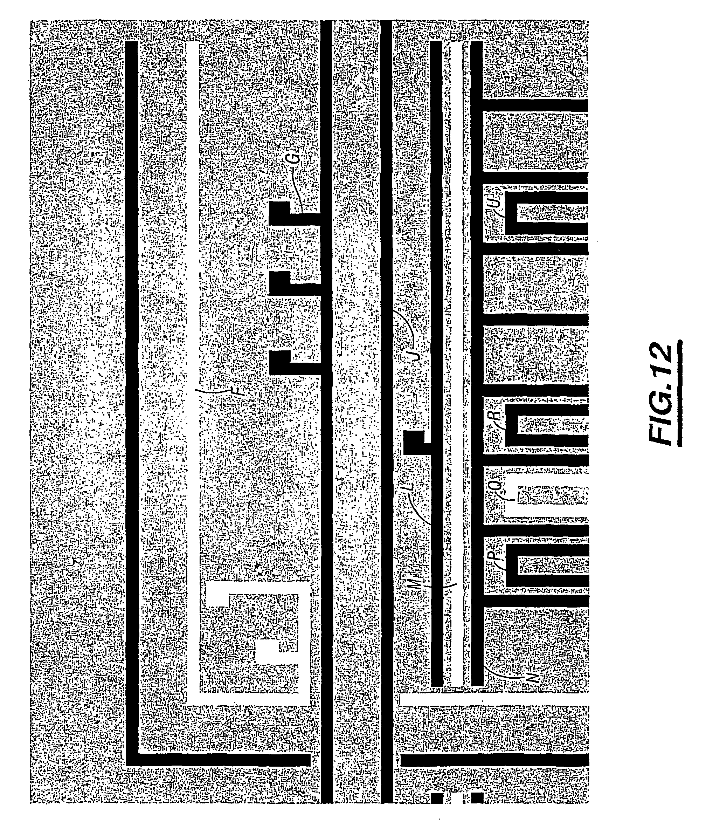

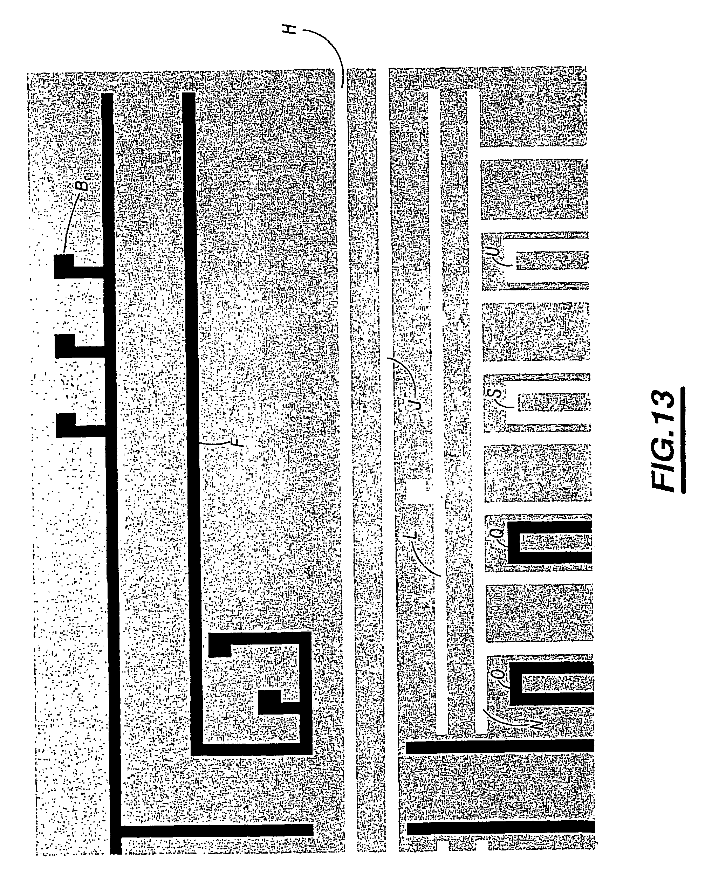

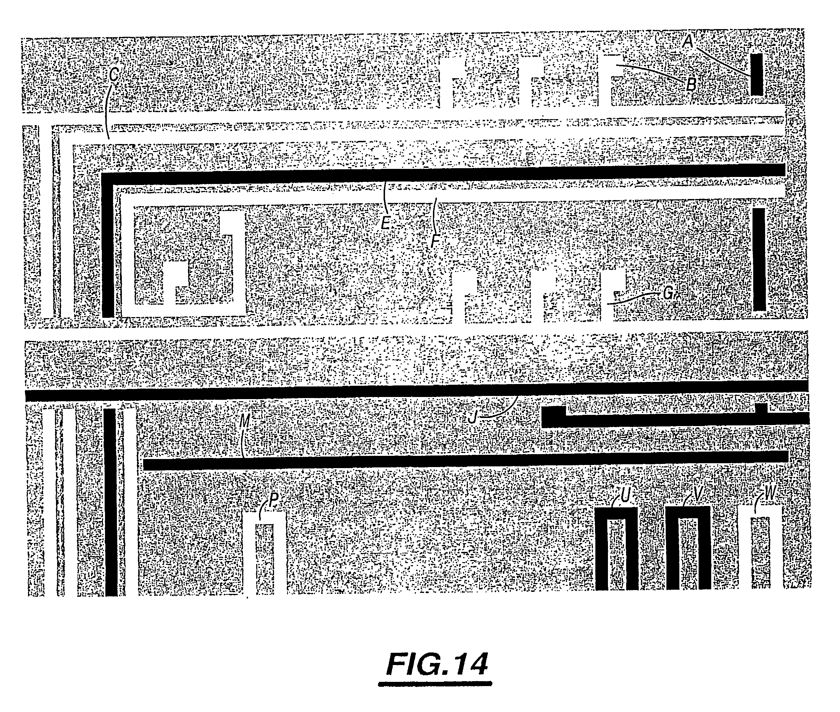

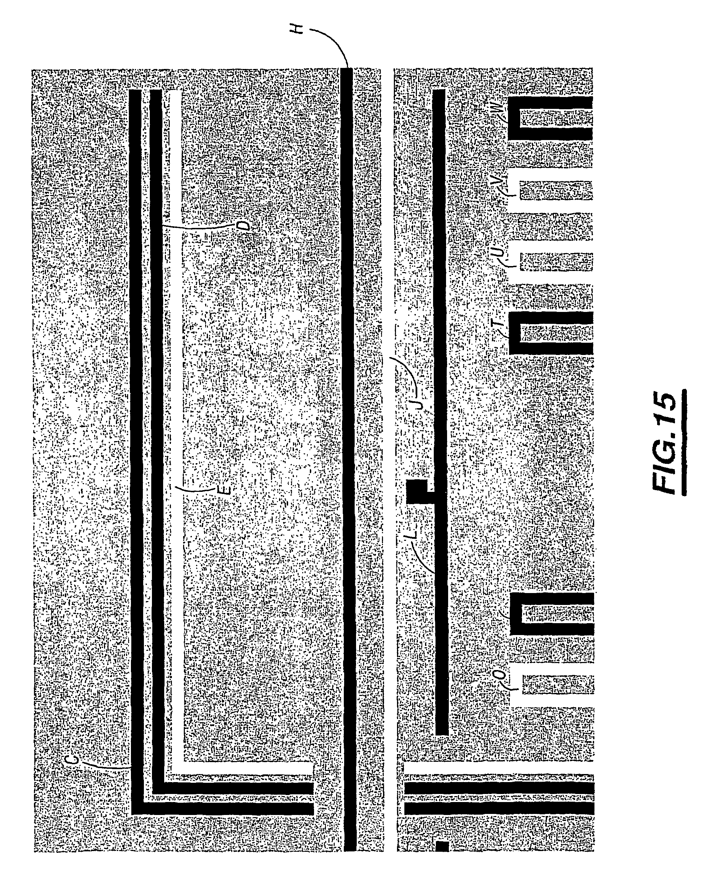

Sur les figures 5 à 15 sont représentées les images du circuit en fonctionnement telles qu'elles sont produites par un microscope électronique à balayage après traitement numérique visant à réduire le nombre de nuance de couleur à trois, à savoir le noir, le blanc et le gris.

Les images des figures 5 à 15 sont respectivement les images du circuit tel qu'il apparaît aux instants correspondants aux 11 premières lignes de la matrice ternaire présentée dans la suite.

Suivant les règles définies ci-dessus, la conversion de la matrice des états logiques binaires en une matrice ternaire conduit à l'obtention de la matrice présentée ci-dessous.

| | élément | A | B | C | D | E | F | G | H | I | J | L | M | N | O | P | Q | R | S | T | U | V | W |
|---|---|---|---|---|---|---|---|---|---|---|---|---|---|---|---|---|---|---|---|---|---|---|---|
| vecteur | 1 | N | B | G | B | G | G | N | B | B | G | G | G | G | N | G | G | G | B | N | G | N | N |
| vecteur | 2 | B | N | N | G | G | N | B | G | G | B | G | N | B | G | N | G | G | G | B | G | B | G |
| vecteur | 3 | G | B | G | G | N | B | N | G | N | N | G | G | N | G | G | N | N | G | N | G | N | G |
| vecteur | 4 | G | N | G | N | B | G | G | N | B | B | G | G | G | G | G | G | B | N | B | G | G | G |
| vecteur | 5 | N | G | G | B | G | N | G | B | N | G | G | B | B | G | G | G | G | G | G | G | G | G |
| vecteur | 6 | G | B | B | N | N | G | B | N | B | G | G | G | G | B | B | G | G | B | N | N | G | B |
| vecteur | 7 | B | G | G | B | B | G | G | G | G | G | B | N | G | G | G | G | G | N | B | B | B | N |
| vecteur | 8 | G | G | N | G | G | B | N | G | G | N | N | B | N | G | N | B | N | G | G | N | G | G |
| vecteur | 9 | G | N | G | G | G | N | G | B | G | B | B | G | B | N | G | N | G | B | G | B | G | G |
| vecteur | 10 | N | B | B | G | N | B | B | G | G | N | G | N | G | G | B | G | G | G | G | N | N | B |
| vecteur | 11 | G | G | N | N | B | G | G | N | G | B | N | G | G | B | N | G | G | G | N | B | B | N |
| vecteur | 12 | B | G | G | G | N | N | N | G | N | N | G | G | G | N | B | B | G | N | B | N | N | B |
| vecteur | 13 | N | N | B | B | G | B | B | G | B | B | B | G | N | G | N | N | G | B | N | G | B | N |
| vecteur | 14 | B | B | N | G | B | G | N | G | G | G | N | B | G | G | B | B | G | N | B | G | N | B |
| vecteur | 15 | G | G | G | N | G | N | B | G | N | G | B | N | B | B | G | G | G | B | G | G | B | N |
| vecteur | 16 | N | N | B | B | N | G | N | G | G | G | N | G | G | G | G | N | B | G | G | G | N | B |
| vecteur | 17 | B | G | N | G | B | B | B | G | G | G | G | G | N | G | G | G | G | G | G | B | B | G |
| vecteur | 18 | N | B | B | N | N | G | G | B | B | G | G | B | G | G | G | G | G | N | G | N | G | G |
| vecteur | 19 | G | G | G | G | B | G | G | G | G | G | G | N | B | N | G | B | G | B | N | B | N | N |
| vecteur | 20 | G | G | N | B | N | G | N | N | G | N | B | G | N | G | N | G | G | N | G | N | B | G |
| vecteur | 21 | G | N | G | N | G | G | G | B | G | B | N | B | G | B | B | N | N | B | B | G | N | B |
| vecteur | 22 | B | G | G | B | B | G | B | N | N | N | G | N | G | N | G | G | G | N | N | B | B | G |
| vecteur | 23 | N | G | G | N | N | G | N | G | G | G | B | G | G | G | G | G | G | G | B | G | G | G |

A partir de cette matrice, un arbre temaire est créé dans lequel, les noeuds de l'arbre correspondent à des vecteurs résultats obtenus par comparaison d'un vecteur résultat antérieur et de l'un des vecteurs de la matrice ternaire par application de l'un de trois opérateurs logiques compaN, compaB, compaG, chacun de ces opérateurs étant construit sur le modèle des opérateurs compa1 et compa0.

Les tables de vérité des trois opérateurs logiques sont données ci-dessous:

| X | Y | compaN | compaB | compaG |
|---|---|---|---|---|
| N | N | N | | |
| N | B | | B | |
| N | G | | | G |
| B | N | N | | |
| B | B | | B | |
| B | G | | | G |
| G | N | N | | |
| G | B | | B | |
| G | G | | | G |

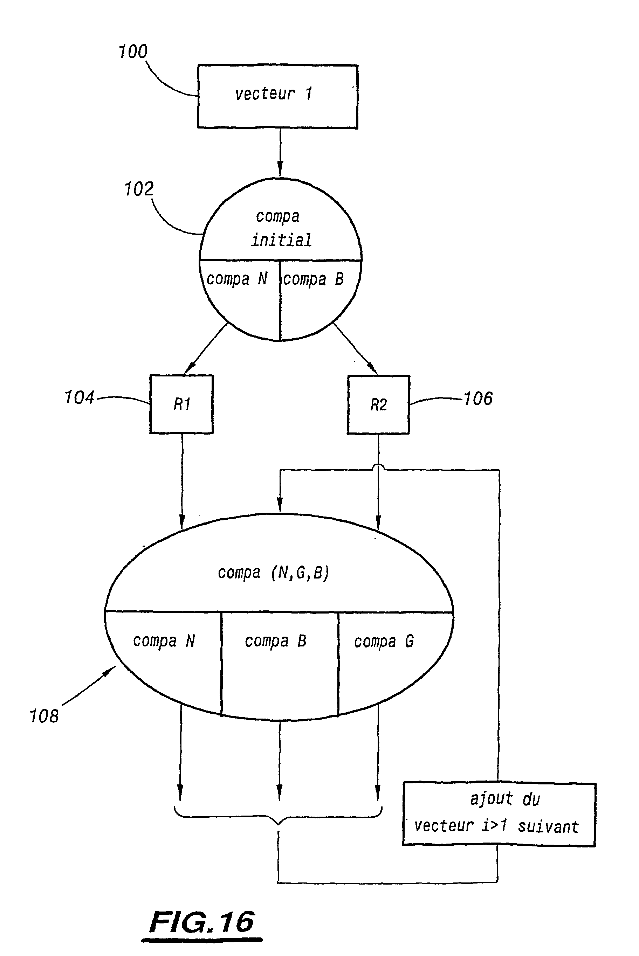

Sur la figure 16 est représenté de manière simplifiée, l'organigramme de l'algorithme de création de l'arbre ternaire par application des opérateurs logiques compaN, compaB et compaG.

Initialement, à l'étape 100, le vecteur 1 de la matrice ternaire est considéré. Le vecteur 1 est comparé à l'étape 102, à un premier vecteur résultat RO dont tous les coefficients sont pris égaux à N, (respectivement B) par application des opérateurs logiques compaN, (respectivement compaB). Des vecteurs R1 et R2 sont ainsi créés en 104 et 106.

Une procédure récursive est alors mise en oeuvre en 108 pour effectuer les comparaisons des vecteurs résultats précédemment créés avec les autres vecteurs de la matrice en appliquant chacun des opérateurs compaN, compaB, compaG. Cette procédure est illustrée par une boucle sur la figure 16.

A partir de l'arbre ternaire ainsi obtenu, pour individualiser un élément particulier du circuit, une combinaison d'images est effectuée par application d'une composée d'opérateurs graphiques splitbyN, splitbyB et splitbyG, ces opérateurs correspondent respectivement aux opérateurs logiques compaN, compaB et compaG.

Les opérateurs graphiques splitbyN, splitbyB et splitbyG assurent sur des images à trois niveaux de couleurs (noir, blanc et gris), la combinaison de deux images pixel à pixel pour les éléments respectivement noirs, blancs et gris.

On conçoit que la combinaison d'images correctement déterminées, effectuée par comparaison pixel à pixel des images, permet de faire disparaître de l'image traitée finale l'essentiel des éléments de circuit non désirés, individualisant ainsi sur l'image l'élément de circuit recherché.

A titre d'exemple, les premières phases de mise en oeuvre de l'algorithme permettant d'individualiser les éléments A et B sont explicitées ci-dessous.

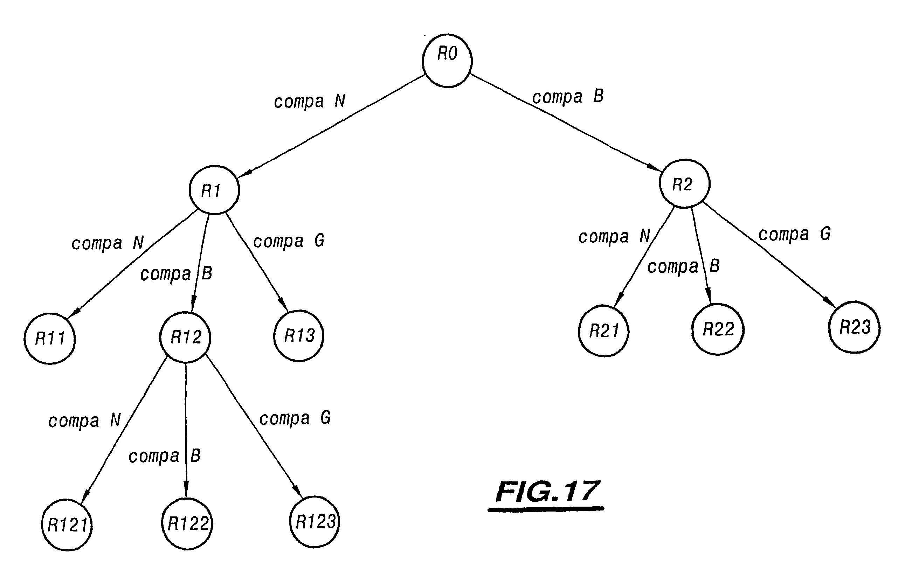

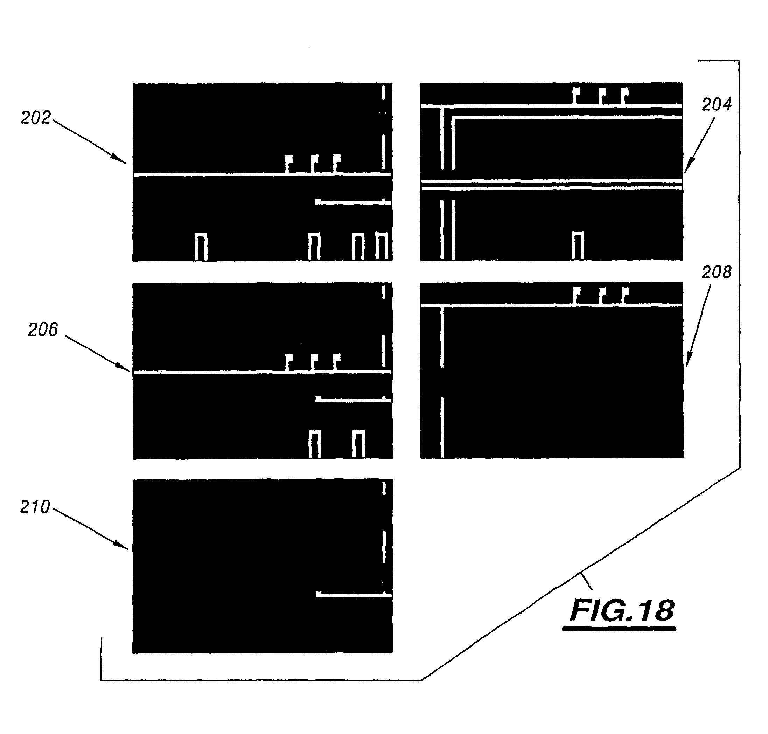

L'arbre créé par mise en oeuvre de l'algorithme est donné sur la figure 17 alors que les images associées aux noeuds principaux de l'arbre sont données sur la figure 18.

Par mise en oeuvre du procédé, le vecteur 1 est d'abord comparé au vecteur RO par application des opérateurs logiques compaN et compaB pour donner les vecteurs résultants R1 et R2. Le calcul de ces vecteurs est donné dans le tableau 6 figurant à la fin de la description.

Les images créées correspondant aux vecteurs.résultat R1 et R2 par application sur l'image de la figure 5, des opérateurs splitbyN et splitbyB respectivement sont données sur la figure 18 où elles sont désignées par les numéros de références 202 et 204.

A partir du vecteur résultat R1, de nouvelles comparaisons sont effectuées pour former les vecteurs résultat de niveau supérieur R11, R12 et R13 comme explicité dans le tableau 7.1 figurant à la fin de la description.

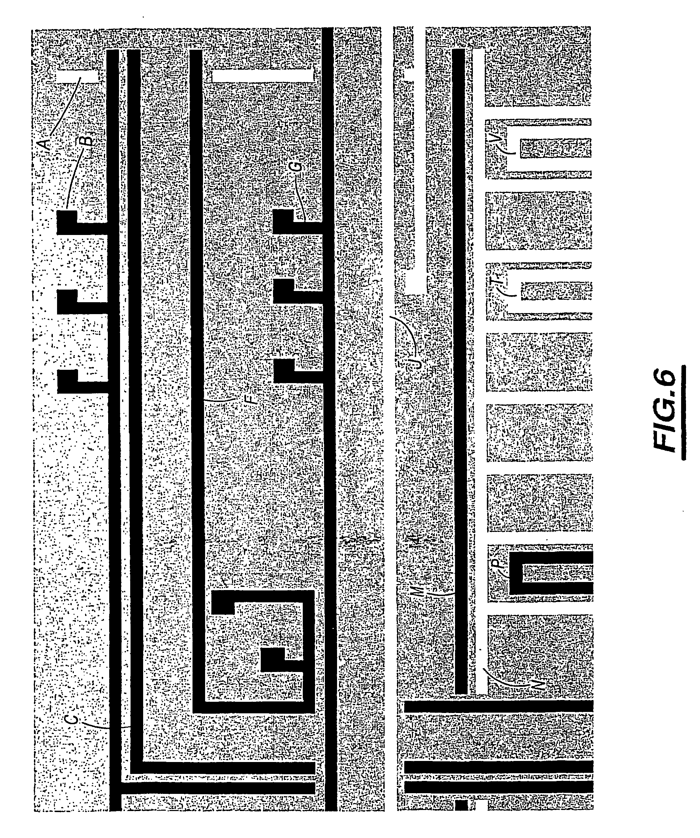

L'image correspondant au vecteur résultat R11 est représentée sur la figure 18 où elle est désignée par la référence 206. Cette image est formée par application de l'opérateur graphique splitbyB sur l'image 202 et l'image de la figure 6 correspondant au vecteur 2.

De manière analogue, à partir du vecteur résultat R2, les vecteurs résultat de niveau supérieur R21, R22 et R23 sont formés comme explicité dans le tableau 7.2 figurant à la fin de la description.

L'image correspondant au vecteur résultat R21 est représentée sur la figure 18 où elle est désignée par la référence 208.

Cette image est formée par application de l'opérateur graphique splitbyN sur l'image 204 et l'image de la figure 6 correspondant au vecteur 2.

Sur l'image 208, l'élément B est seul présent puisque comme cela apparaît dans le tableau 7.2, la seule composante non nulle du vecteur résultat R21 est celle figurant dans la colonne correspondant à l'élément B.

Le vecteur résultat R12 pouvant encore être divisé, de nouvelles étapes de comparaison sont conduites sur la base de ce vecteur pour former les vecteurs résultat de niveau supérieur R121, R122 et R123 comme illustré dans le tableau 8.

Les vecteurs résultat sont formés à partir de la comparaison du vecteur 3 et du vecteur résultat R12 par application des trois opérateurs logiques.

L'image correspondant au vecteur R123 est donnée sur la figure 18 et est désignée par la référence 210.

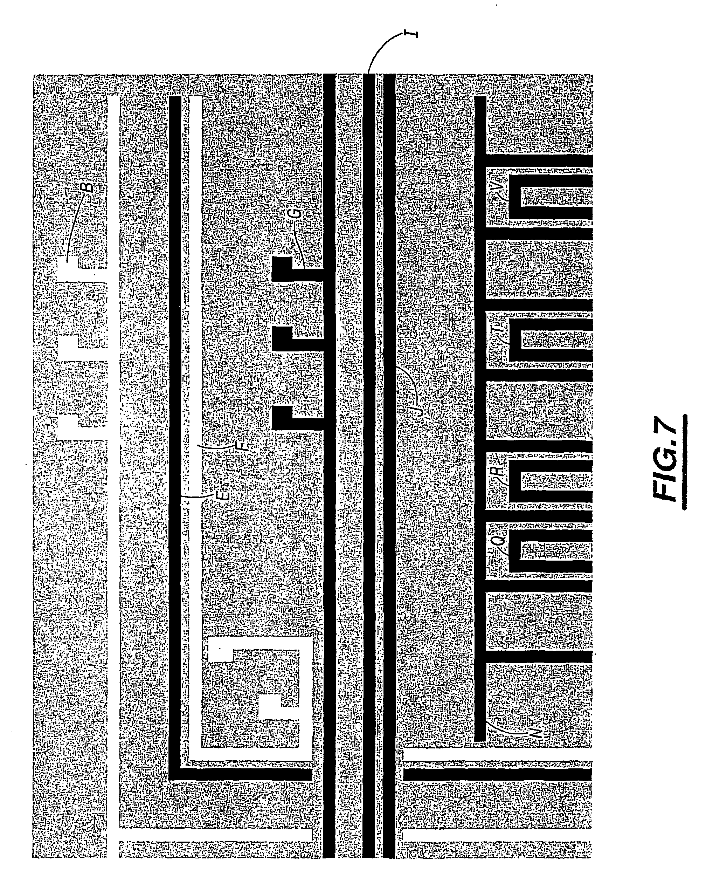

Cette image est formée par application de l'opérateur graphique splitbyG sur l'image 208 et sur l'image de la figure 7 correspondant au vecteur 3.

Sur l'image 210, l'élément A apparaît seul puisque la seule composante non nulle du vecteur résultat R123 est celle figurant dans la première colonne correspondant à l'élément A.

On comprend qu'en poursuivant ainsi la mise en oeuvre de l'algorithme, chacun des éléments du circuit peut être individualisé.

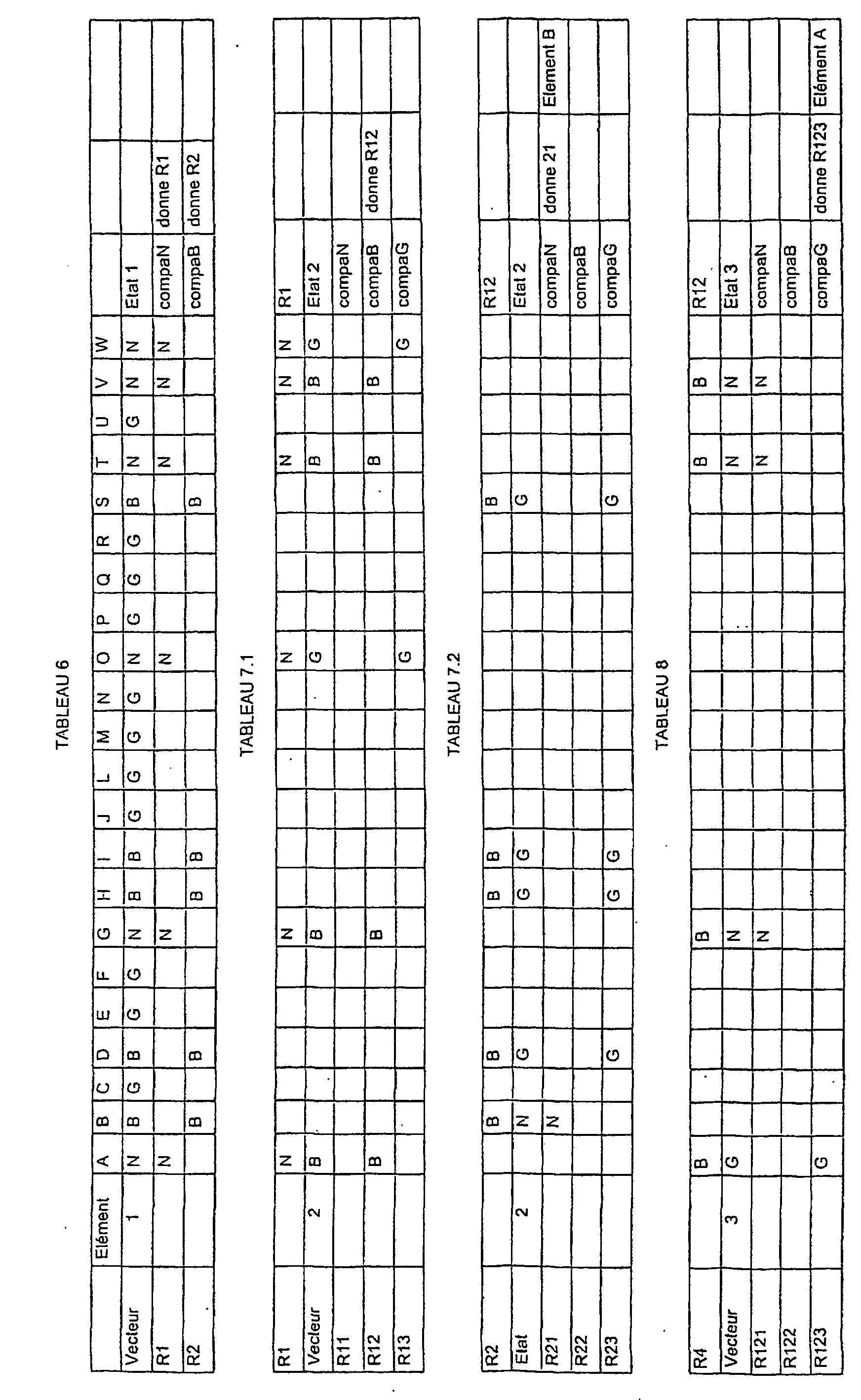

## Revendications

1. Procédé d'individualisation d'un élément de circuit intégré, **caractérisé en ce qu'**il comporte les étapes consistant en :
a) déterminer à partir d'un modèle du circuit, un ensemble de vecteurs (1) correspondant chacun à un instant de fonctionnement théorique du circuit lors de l'application d'une séquence de tests prédéterminée, les coefficients de chaque vecteur étant représentatifs de l'état d'un même ensemble d'éléments du circuit parmi lesquels figurent l'élément à individualiser;
b) définir à partir d'une comparaison des vecteurs, une composée d'opérateurs logiques (2) appliqués sur lesdits vecteurs et permettant d'extraire le coefficient correspondant auxdits éléments à individualiser ;
c) réaliser des images du circuit (32) en fonctionnement aux instants correspondants aux vecteurs sur lesquels est appliquée ladite composée d'opérateurs logiques ; et
d) combiner graphiquement (36) les images réalisées suivant une composée d'opérateurs graphiques correspondant à ladite composée d'opérateurs logiques.

2. Procédé d'individualisation selon la revendication 1, **caractérisé en ce que** l'étape b) de définition d'une composée d'opérateurs logiques comporte une étape récursive de comparaison d'un vecteur de la matrice et d'un vecteur résultat obtenu à partir d'une comparaison antérieure (24,26).

3. Procédé d'individualisation selon la revendication 2, **caractérisé en ce que** l'étape b) de définition d'une composée d'opérateurs logiques comporte l'élaboration d'un arbre dont les noeuds sont constitués des résultats des comparaisons effectuées.

4. Procédé d'individualisation selon l'une quelconque des revendications, **caractérisé en ce que** ledit ensemble de vecteurs est un ensemble de vecteurs binaires, les coefficients étant représentatifs de l'état logique de l'élément de circuit associé.

5. Procédé d'individualisation selon l'une quelconque des revendications de 1 à 3, **caractérisé en ce que** ledit ensemble de vecteurs est un ensemble de vecteurs ternaires, les coefficients étant représentatifs d'un changement d'état logique de l'élément de circuit associé.

6. Procédé d'individualisation selon l'une quelconque des revendications précédentes, **caractérisé en ce qu'**il comporte avant l'étape b) de définition d'une composée d'opérateurs logiques, une étape de classement des vecteurs afin d'augmenter leur diversité.

7. Dispositif d'individualisation d'un élément de circuit intégré, **caractérisé en ce qu'**il comporte :
- des moyens pour déterminer à partir d'un modèle du circuit, un ensemble de vecteurs (1) correspondant chacun à un instant de fonctionnement théorique du circuit lors de l'application d'une séquence de tests prédéterminée, les coefficients de chaque vecteur étant représentatifs de l'état d'un même ensemble d'éléments du circuit parmi lesquels figurent l'élément à individualiser ;
- des moyens pour définir à partir d'une comparaison des vecteurs, une composée d'opérateurs logiques (2) appliqués sur lesdits vecteurs et permettant d'extraire le coefficient correspondant auxdits éléments à individualiser ;
- des moyens pour réaliser des images du circuit (32) en fonctionnement aux instants correspondants aux vecteurs sur lesquels est appliquée ladite composée d'opérateurs logiques ; et
- des moyens pour combiner graphiquement (36) les images réalisées suivant une composée d'opérateurs graphiques correspondant à ladite composée d'opérateurs logiques.

## Patentansprüche

1. Verfahren zur Individualisierung eines Elements einer integrierten Schaltung, **dadurch gekennzeichnet, dass** es die Schritte enthält, die bestehen aus:
a) auf der Basis eines Schaltungsmodells einen Satz von Vektoren (1) festlegen, von denen jeder einem theoretischen Funktionszeitpunkt der Schaltung während der Anwendung einer vorgegebenen Testsequenz entspricht, wobei die Koeffizienten jedes Vektors für den Zustand eines gleichen Satzes von Elementen der Schaltung repräsentativ sind, zu denen das zu individualisierende Element gehört;
b) ausgehend von einem Vergleich der Vektoren eine Zusammensetzung von logischen Operatoren (2) definieren, die auf die Vektoren angewendet werden und es ermöglichen, den Koeffizienten zu extrahieren, der den zu individualisierenden Elementen entspricht;
c) Bilder der Schaltung (32) während des Betriebs in den Augenblicken umsetzen, die den Vektoren entsprechen, auf welche die Zusammensetzung von logischen Operatoren angewendet wird; und
d) die umgesetzten Bilder gemäß einer Zusammensetzung von graphischen Operatoren, die der Zusammensetzung von logischen Operatoren entspricht, graphisch kombinieren (36).

2. Verfahren zur Individualisierung nach Anspruch 1, **dadurch gekennzeichnet, dass** der Schritt b) des Definierens einer Zusammensetzung von logischen Operatoren einen rekursiven Schritt zum Vergleichen eines Vektors der Matrix und eines Vektorergebnisses umfaßt, das aus einem vorherigen Vergleich (24, 26) erhalten wurde.

3. Verfahren zur Individualisierung nach Anspruch 2, **dadurch gekennzeichnet, dass** der Schritt b) des Definierens einer Zusammensetzung von logischen Operatoren die Ausarbeitung eines Baums umfaßt, dessen Knoten aus den Ergebnissen der ausgeführten Vergleiche gebildet werden.

4. Verfahren zur Individualisierung nach einem der Ansprüche, **dadurch gekennzeichnet, dass** der Satz von Vektoren ein Satz von binären Vektoren ist, wobei die Koeffizienten für den logischen Zustand des damit verbundenen Schaltungselements repräsentativ sind.

5. Verfahren zur Individualisierung nach einem der Ansprüche 1 bis 3, **dadurch gekennzeichnet, dass** der Satz von Vektoren ein Satz von ternären Vektoren ist, wobei die Koeffizienten für eine Änderung des logischen Zustands des damit verbundenen Schaltungselements repräsentativ sind.

6. Verfahren zur Individualisierung nach einem der vorhergehenden Ansprüche, **dadurch gekennzeichnet, dass** es vor dem Schritt b) des Definierens einer Zusammensetzung von logischen Operatoren einen Klassifizierungsschritt für die Vektoren umfaßt, um ihre Vielfalt zu erhöhen.

7. Vorrichtung zur Individualisierung eines Elements einer integrierten Schaltung, **dadurch gekennzeichnet, dass** sie enthält:
- Mittel, um auf der Basis eines Schaltungsmodells einen Satz von Vektoren (1) festzulegen, von denen jeder einem theoretischen Funktionszeitpunkt der Schaltung während der Anwendung einer vorgegebenen Testsequenz entspricht, wobei die Koeffizienten jedes Vektors für den Zustand eines gleichen Satzes von Elementen der Schaltung repräsentativ sind, zu denen das zu individualisierende Element gehört;
- Mittel, um ausgehend von einem Vergleich der Vektoren eine Zusammensetzung von logischen Operatoren (2) zu definieren, die auf die Vektoren angewendet werden und es ermöglichen, den Koeffizienten zu extrahieren, der den zu individualisierenden Elementen entspricht;
- Mittel, um Bilder der Schaltung (32) während des Betriebs in den Augenblicken umzusetzen, die den Vektoren entsprechen, auf welche die Zusammensetzung von logischen Operatoren angewendet wird; und
- Mittel, um die umgesetzten Bilder gemäß einer Zusammensetzung von graphischen Operatoren, die der Zusammensetzung von logischen Operatoren entspricht, graphisch zu kombinieren (36).

## Claims

1. Method of customising an integrated circuit element, **characterised in that** it comprises the following steps consisting of :
a) determining, from a circuit model, a set of vectors (1) each corresponding to a theoretical functioning of the circuit at a given instant during the application of a predetermined sequence of tests, the coefficients of each vector being representative of the state of the same set of circuit elements which include the element to be customised;
b) defining, by comparing the vectors, a combination of logic operators (2) applied to the said vectors and enabling the coefficient to be extracted which corresponds to the said elements to be customised;
c) producing images from the circuit (32) as it functions at instants corresponding to the vectors to which the said combination of logic operators is applied; and
d) graphically combining (3b) the images produced according to a combination of graphic operators corresponding to the said combination of logic operators.

2. Customising method according to claim 1, **characterised in that** the step (b) for defining a combination of logic operators comprises a recursive step for comparing a vector from the matrix and a resultant vector obtained from an earlier comparison (24, 26).

3. Customising method according to claim 2, **characterised in that** the step (b) for defining a combination of logic operators comprises the generation of a tree, the nodes of which are formed from the results of comparisons carried out.

4. Customising method according to any of the claims, **characterised in that** the said set of vectors is a set of binary vectors, the coefficients being representative of the logic state of the associated circuit element.

5. Customising method according to any of claims 1 to 3, **characterised in that** the said set of vectors is a set of ternary vectors, the coefficients being representative of a change in the logic state of the associated circuit element.

6. Customising method according to any of the preceding claims, **characterised in that** it comprises, before step (b) for determining a composite of logic operators, a step for classifying the vectors so as to increase their diversity.

7. Device for customising an integrated circuit element, **characterised in that** it comprises:
- means for determining, from a circuit model, a set of vectors (1) each corresponding to a theoretical functioning of the circuit at a given instant during the application of a predetermined sequence of tests, the coefficients of each vector being representative of the state of the same set of circuit elements including the element to be customised;
- means for defining, by comparing the vectors, a combination of logic operators (2) applied to the said vectors and enabling the coefficient to be extracted which corresponds to the said elements to be customised;
- means for producing images from the circuit (32) as it functions at instants corresponding to the vectors to which the said combination of logic operators is applied; and
- means for graphically combining (36) images produced according to a combination of graphic operators corresponding to the said combination of logic operators.
